(19) Europäisches Patentamt
European Patent Office
Office européen des brevets

(11) Publication number: **0 095 048**
**B1**

(12) # EUROPEAN PATENT SPECIFICATION

(45) Date of publication of patent specification: **30.11.88**

(51) Int. Cl.⁴: **H 01 L 23/14,** H 01 L 21/312, G 03 C 1/68

(21) Application number: **83104063.9**

(22) Date of filing: **26.04.83**

(54) **Oligomer coated electronic circuit component and method of coating.**

(30) Priority: **24.05.82 US 381485**

(43) Date of publication of application:
**30.11.83 Bulletin 83/48**

(45) Publication of the grant of the patent:
**30.11.88 Bulletin 88/48**

(84) Designated Contracting States:
**DE FR GB**

(56) References cited:
**US-A-4 258 079**
**US-A-4 273 906**

(73) Proprietor: **International Business Machines Corporation**
**Old Orchard Road**
**Armonk, N.Y. 10504 (US)**

(72) Inventor: **Clark, Roger J.**
**R.D. No. 2, P.O. Box 540 Packard Road**
**Underhill, VT 05489 (US)**
Inventor: **Economy, James**
**6694 Heathfield Drive**
**San José, CA 95193 (US)**
Inventor: **Flanders, Mary A.**
**824 Prescott Avenue**
**Endicott, Ny 13760 (US)**
Inventor: **Susko, John R.**
**P.O. Box 41**
**Owego, NY 13827 (US)**
Inventor: **Wheater, Robin A.**
**P.O. Box 8, R.D. No. 3**
**Owego, NY 13827 (US)**

(74) Representative: **Louet Feisser, Arnold et al**
**Intellectual Property Department IBM Nederland**
**N.V. Watsonweg 2**
**NL-1423 ND Uithoorn (NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 095 048 B1

Courier Press, Leamington Spa, England.

## Description

### Technical Field

The present invention is concerned with coating a substrate which contains an electrically conductive pattern on at least one major surface of the substrate and is especially concerned with providing a top seal to coat solder connector patterns under an attached integrated circuit chip. The present invention is also concerned with the method for providing such a coating. In addition, the present invention is concerned with the use of certain preferred compositions for providing a top seal.

### Background Art

During the preparation of integrated circuit modules, input/output (I/O) pins are inserted into a substrate. The input/output pins provide the needed electrical connections to the integrated circuit chip or chips which are subsequently connected to the substrate or carrier. The integrated circuit chips are attached to the integrated circuit substrate or carrier by applying solder to preselected areas on the substrate which are generally referred to in the art as the "chip pad areas". Such areas can be defined, for instance, by providing preselected exposed areas of a metal which will accept the solder, such as copper. In addition, a solder flux composition is normally applied to the substrate to facilitate the application of the solder to the chip pad area. After solder is applied to the chip pad area, any flux and/or flux residue is removed prior to attaching the integrated circuit chip so as to provide as clean a module as possible.

After attachment of the integrated circuit chip(s) and subsequent flux residual removal, a top seal coating composition is applied to the integrated circuit module in order to protect the top side of the module which contains the integrated circuit chip from corrosion and/or electromigration.

Top seal compositions are employed in order to prevent failure of the substrate and device due to corrosion; to immobilize conductive particles; to extend the thermal fatigue life of the solder interconnection between the substrate and chip; and to act as a protective barrier for alpha particle sensitive semiconductors. However, the top seal compositions which are now commercially employed, although for the most part satisfactory, do not provide all of the above desirable functions to a satisfactory degree. For instance, the top seal compositions now employed provide satisfactory levels of at most three of the above functions. Accordingly, depending upon desired use of the integrated circuit module, one or more of the above functions is normally compromised by the selection of the particular top seal composition employed. One of the more common types of top seal compositions employed is obtained from curing a composition containing as the binder a polyamide-imide.

In addition, the top seal composition must possess the type of flow characteristics needed to coat the solder pattern in a reliable and controllable manner.

### Summary of Invention

Reference should now be made to the appended claims in which the invention is set out.

The present invention makes it possible to achieve all of the above-discussed objectives desired from a top seal composition at satisfactory levels, and, therefore, none of such functions need to be compromised. In particular, the present invention provides for uniform coating of complex solder connection patterns under an attached integrated circuit chip. Moreover, the present invention provides for an excellent α particle barrier beneath the chip and provides for excellent passivation of the metallurgy on the chip. In addition, the coatings, applied in accordance with the present invention, are extremely thermally stable and are tough when cured. Moreover, the coatings when formed from the compositions used by the present invention are essentially free from pinholes.

In particular, the present invention is concerned with an electronic circuit component which includes a substrate; an integrated circuit chip attached to an electrically conductive pattern formed on the substrate; and a coating top seal over the conductive pattern on at least one surface of the substrate, and in particular under the attached chip.

The top seal coating is a continuous film formed from a soluble, polymerizable oligomer having a number average molecular weight of from 200 to 10,000, having more than two appendant acetylenic groups and having the formula:

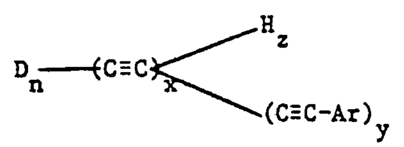

wherein D is

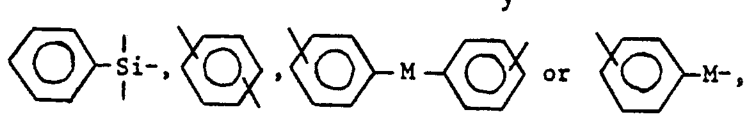

wherein M is

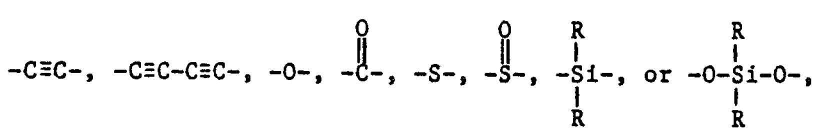

wherein R is an alkyl or aromatic group; wherein Ar is an aromatic group; wherein x is the number of appendant acetylenic groups and is an integer greater than two but less than 30, z is either zero or an integer, and y is an integer with the sum of y and z equal to x; and wherein n is an integer from 1 to 10.

Moreover, the present invention is concerned with a method for providing a coating on a substrate which substrate contains an electrically conductive pattern. The process comprises coating at least one major surface of the substrate with a composition containing a soluble polymerizable oligomer as described hereinabove and then hardening the composition by further polymerization of the oligomer.

Another aspect of the present invention is to use, in the top seal composition which contains a soluble polymerizable oligomer as described hereinabove, at least one plasticizer and/or at least one toughener. The plasticizer can be diphenyl diacetylene, and/or diphenylbutadiene, and/or diphenylether, and/or phenyltriethynyl silane, and/or 4,4'-diethynyldiphenyl ether. The toughener can be aromatic diphenyl ether; acrylonitrile polymers, polyimides, polyesters, polysilicones, polyquinoxalines, cyclized poly-(arylacetylene) polymers or mixtures of any of the above. The plasticizer and/or toughener are present in an amount sufficient to increase the fluidity and/or toughness of the composition.

Description of Drawing

The Figure is a schematic cross section of a substrate and chip containing a top seal composition in accordance with the present invention.

Best and Various Modes for Carrying Out Invention

According to the present invention, a continuous film is formed on a substrate from a composition containing a soluble, polymerizable oligomer having a number average molecular weight of from 200 to 10,000, having more than two appendant acetylenic groups and having the general formula:

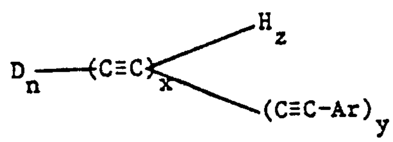

wherein D is

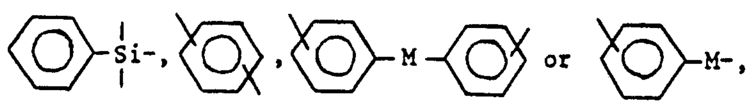

wherein M is

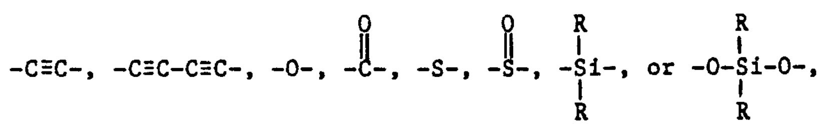

wherein R is an alkyl or aromatic group; wherein Ar is an aromatic group; wherein x is an integer greater than two but less than 30, z is either zero or an integer, and y is an integer with the sum of y and z equal to x; and wherein n is an integer from 1 to 10. Preferably, such R alkyl groups contain 1—6 carbon atoms and such aromatic groups contain 6—10 carbon atoms.

Oligomers employed according to the present invention are disclosed along with a method for the preparation thereof in U.S. Patents 4,258,079 and 4,273,906. The oligomers are prepared by reacting a monomer containing at least two acetylenic groups in the presence of a molar excess over the monomer of an aromatic monoacetylenic capping agent and in the presence of an oxygen-carrying amine-basic cupric salt complex catalyst. The preferred capping agent is an aromatic monoethynyl compound which can be represented by the formula:

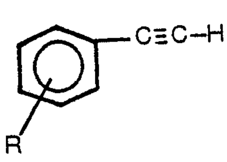

wherein R is H, halogen, lower alkyl containing up to 6 carbon atoms, or lower alkoxy containing up to 6 carbon atoms. The most preferred capping agent is phenylacetylene. The single ethynyl group of the capping agent enters into the coupling reaction, but because the molecule has only one ethynyl group, further coupling is terminated. A molar excess of the capping agent is employed so that the molecular weight of the oligomer is properly controlled.

Examples of amines employed to provide the catalyst include pyridine and alkylene polyamines such as tetramethylethylene diamine. A suitable copper salt to employ to provide the catalyst is CuCl. The catalyst can be preoxidized by bubbling $O_2$ through the mixture for several minutes before the addition of the catalyst to the reaction mass.

The oligomers employed in the present invention are preferably obtained from 1,3,5-triethynylbenzene. The preferred molecular weight of oligomers employed in the present invention is 400 to 2000. Preferably, at least 60% of the acetylenic groups for purposes of the present invention are diacetylenic and most preferably each oligomer molecule contains at least two diacetylenic groups. It is most preferred that diacetylenic groups constitute most of the appendant acetylenic groups.

The preferred oligomers have up to 20% ethynyl content. Mixtures of the above oligomers can be employed. In addition, the ingredients in D in the above formula may be mixtures of the materials specified. By polymerizing mixtures of the oligomers, useful copolymers can be obtained. Furthermore, the aromatic groups can be substituted such as by alkyl groups of up to 6 carbon atoms and by halogens. Such substituents do not enter into or interfere with the polymerization reaction. However, because the compositions are intended for high temperature use, preferably alkyl groups are not present in view of their tendency to degrade at elevated temperatures. Examples of aromatic groups include phenyl and biphenyl.

The most preferred oligomer employed according to the present invention has the following characteristics:

6—20% free ethynyl groups per aromatic ring.

$\overline{M}_z = \sim 1500—2500$

$\overline{M}_w = \sim 1000—1200$

$\overline{M}_n = \sim 700— 900$

The preferred oligomers employed in the present invention can be prepared in accordance with Example 1 or Example 2 of U.S. Patent 4,273,906 and most preferably in accordance with Example 2.

The coating compositions employed according to the present invention preferably contain a toughening agent and/or plasticizer and are preferably employed in solution form. Examples of suitable plasticizers include diphenyldiacetylene, diphenylbutadiene, (i.e.

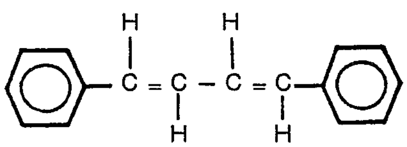),

diphenylether, phenyltriethynyl silane, and 4,4′-diethynyldiphenyl ether.

Examples of suitable tougheners include aromatic diphenyl ether, cyclized poly(arylacetylene) polymers, acrylonitrile polymers such as copolymers of acrylonitrile and styrene, and of acrylonitrile and butadiene, polyimides, polyquinoxalines, polyesters, and polysilicones. The preferred tougheners are aromatic diphenylether and cyclized poly(arylacetylene) polymers such as H-resin commercially available from Hercules Incorporated.

Aromatic diphenylether can be represented by the structure

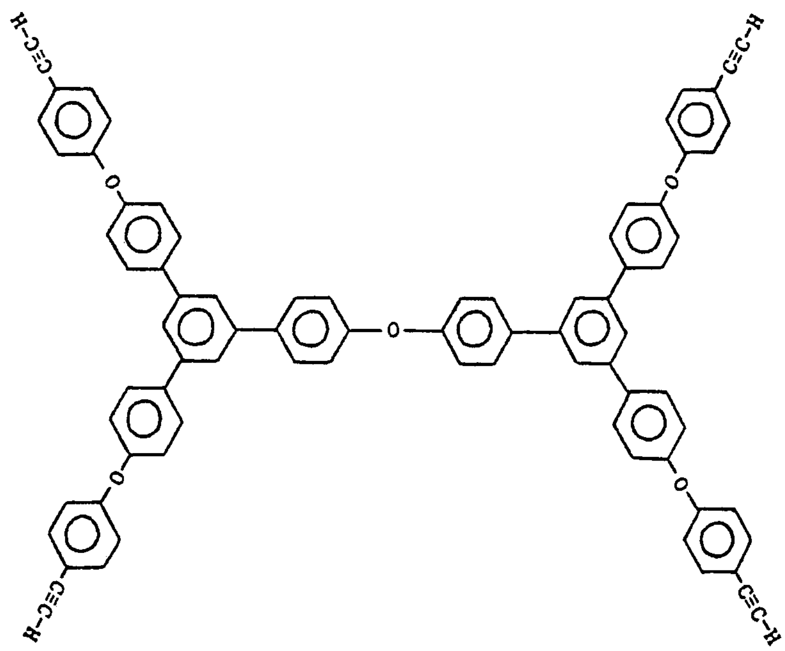

Aromatic diphenyl ether can be prepared by admixing about 1.09 grams of 4,4'-diethynyldiphenyl ether

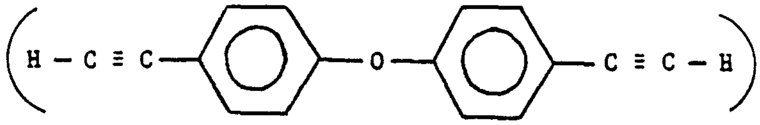

about 0.05 grams of nickel-acetylacetonate, and about 0.10 grams of triphenylphosphine in about 75 ml of dioxane. The solution is heated to about 80°C and allowed to remain at that temperature for about 6 hours with constant stirring. The reaction mixture is then poured onto 500 ml of petroleum ether. The precipitate is collected, washed and dried to provide the desired aromatized 4,4'-diethynyldiphenyl ether.

The preferred cyclized poly(arylacetylene) polymer component is H-resin which is commercially available from Hercules Incorporated, and is a mixture of about 70—80% by weight of a cyclized poly(aryl-acetylene) polymer of the structure

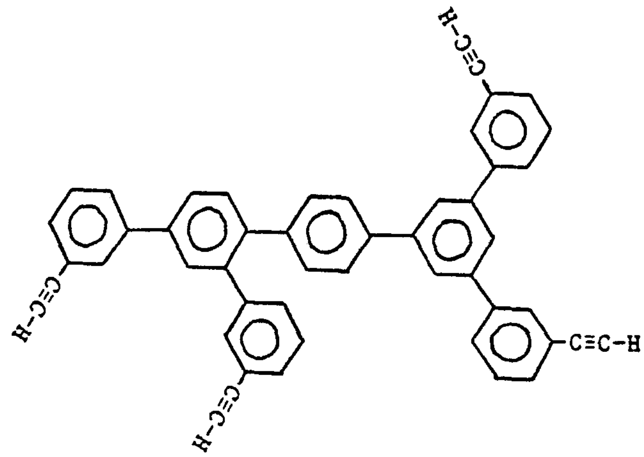

with about 20—30% by weight of diphenyldiacetylene. Such polymers can be prepared in accordance with the procedure suggested in U.S. Patent 4,070,333 to Jabloner.

The polyacetylenically substituted aromatic compounds used to prepare the cyclized poly(aryl-acetylene) can be an aromatic compound which contains at least two acetylenic groups attached to the same aromatic ring or to different aromatic rings in the compound, or mixtures of such compounds. The acetylenic groups can be internal, i.e. acetylene groups of the type aryl-C≡C-aryl, or they can be external, i.e. ethynyl groups of the type aryl-C≡C—H, or both types can be present in the polyacetylenic compound.

Examples of such materials are m- and p-diethynylbenzenes; diethynyl toluenes; diethynyl xylenes; 9,10-diethynylanthracene; diethynylbiphenyl; 9,10-diethynylphenanthrene; 4,4'-diethynyl-trans-azobenzene; di(ethynylphenyl)ether; 2,3,5,6-tetrachloro-1,4-diethynylbenzene; diphenyl-diacetylene; dibenzyl-diacetylene; di-p-tolyldiacetylene; di-α-naphthyldiacetylene; 1-chloro-2,5-diethynylbenzene; 2,2'-dichlorodiphenyldiacetylene; 4,4'-dichlorodiphenyldiacetylene; 4,4'-dibromodiphenyldiacetylene; 1,4-bis-(phenylethynyl)benzene; 1,3-bis(phenylethynyl)benzene; 9,10-bis(phenylethynyl) anthracene; 1,3,5-triethynylbenzene; 1,2,4-triethynylbenzene; 1,3,5-tris(phenylethynyl)-2,4,6-triphenylbenzene; 1,2,4-tris(phenylethynyl)-3,5,6-triphenylbenzene; and tris(ethynylphenyl)benzene.

The reaction can be carried out by heating the polyacetylenically substituted aromatic compound with an aromatization catalyst. The reaction can be carried out in bulk or in the presence of an inert diluent. Any inert diluent can be used, as, for example, ethers such as 1,2-dimethoxyethane, dioxane and tetrahydrofuran, or aromatic hydrocarbons such as benzene, toluene and xylene.

Any aromatization catalyst can be used to effect the cyclization reaction. By the term aromatization catalyst is meant a catalyst that promotes the formation of an aromatic ring by the cyclization of three acetylene groups.

Aromatization catalysts include nickel catalysts such as nickel bis(acrylonitrile), nickel bis(acraldehyde), nickel carbonyl bis(triphenylphosphine), nickel cyanide bis(triphenylphosphine), nickel acetylacetonate in combination with triphenylphosphine, and the Group V—B metal halides such as niobium pentahalides and tantalum pentahalides. The amount of the catalyst used generally will be from about 0.5 to about 5% of the monomer by weight.

The polymerization is carried out by heating the polyacetylenic monomer with the catalyst to a temperature of from 55°C to 250°C, and preferably from 80°C to 150°C. Preferably the reaction is carried out in an inert atmosphere. The reaction is generally stopped at monomer conversion above 30% and below 90%, and preferably at a monomer conversion of from 50% to 90%. By so doing, it is possible to produce a prepolymer having a number average molecular weight of from 900 to 12,000, avoid the production of the

very high molecular weight polymer that is cross-linked and at the same time retain in the prepolymer at least 5%, and preferably 5 to 20%, acetylene groups by weight of the prepolymer for reaction in second stage. At least 50% of the acetylenic unsaturation of the monomer is converted into aromatic structures.

In addition, the above polymers as supplied commercially can contain minor amounts such as 5 to 40% and preferably 20 to 30% by weight based on the polymer of an acetylenically substituted aromatic compound for modifying the flow properties of the polymer. Examples of such compounds are beta-naphthylacetylene, biphenylacetylene, 4-ethynyl-trans-azobenzene, diphenylacetylene, di-m-tolylacetylene, di-o-tolylacetylene, bis(4-ethylphenyl)acetylene, bis(3,4-dimethylphenyl)acetylene, bis(4-chlorophenyl)acetylene, phenyl benzoyl acetylene, beta-naphthylphenylacetylene, di(alpha-naphthyl)acetylene, 1,4-diethynylnaphthalene, 9,10-diethynylanthracene, 4,4'-diethynylbiphenyl, 9,10-diethynylphenanthrene, 4,4'-diethynyl-transazobenzene, 4,4'-diethynyldiphenyl ether, 2,3,5,6-tetrachloro-1,4-diethynylbenzene, diphenylbutadiyne, di-p-tolyl-diacetylene, dibenzyl-diacetylene, 2,2'-dichlorodiphenyl diacetylene, 3,3'-dichlorodiphenyl diacetylene, di(alpha-naphthyl)diacetylene, and diethynyldiphenyl butadiyne.

Polyquinoxalines can be represented by the formula:

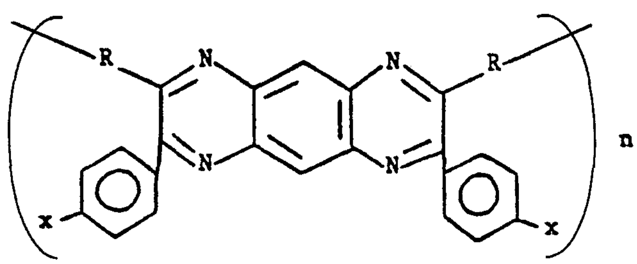

wherein n is an integer of 2 to 25; and R is an arylene group containing 6—10 carbon atoms; or an alkylene group containing 1—6 carbon atoms, or oxybisphenylene and x is an alkyl of 1—6 carbon atoms, or OH, or alkoxy of 1—6 carbon atoms, or aroxy of 6—10 carbon atoms.

The polyquinoxalines can be prepared by reacting

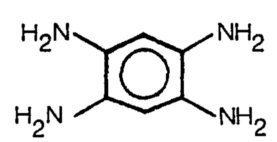 with 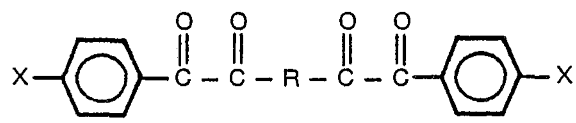

The polyesters employed are preferably obtained from aromatic polycarboxylmic acids. The plasticizers and/or tougheners are generally employed in amounts of 10 to 75% by weight based upon the weight of the oligomer, and preferably 25 to 50% by weight based upon the weight of the oligomer.

In addition, it is preferred that the composition be applied as a solution in order to achieve the most advantageous wetting characteristics, especially when complex solder connection patterns are present connecting the chip to the substrate. The most preferred solvents are the reactive acetylenic solvents as discussed in U.S. Patent 4,258,079. Examples of suitable solvents can be represented by the formula

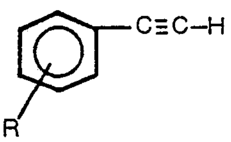

wherein R is H, halogen, lower alkyl of 1—6 carbon atoms, or lower alkoxy of 1—6 carbon atoms. The preferred acetylenic solvent is phenylacetylene. Non-reactive solvents can be employed in place of or in combination with the reactive acetylenic solvents. Examples of suitable non-reactive solvents include alcohols, such as 1-butanol and 2-ethoxyethanol; bis(2-methoxyethyl)ether; cyclohexanone; and 1-methyl-2-pyrrolidinone. Preferably, the non-reactive solvents are oxygen-containing solvents. Preferred solvent systems include mixtures of 1-methyl-2-pyrrolidinone and 2-ethoxyethanol in an amount of 5 to 30 parts of 2-ethyoxyethanol to 70 to 95 parts of 1-methyl-2-pyrrolidinone; 1-methyl-2-pyrrolidinone and 1-butanol in a ratio of 50 parts to 50 parts; and cyclohexanone and 2-ethoxyethanol in a ratio of 60 parts to 40 parts. The amount of oligomer relative to solvent is usually 5 to 75 mg, and preferably 10—50 mg per ml of solvent.

The composition can be applied to the desired assembly of the chip attached to the carrier and permitted to flow to cover the intricate or complex electrical connection pattern between the substrate and the chip. After this, the assembly is subjected to a curing technique in order to further polymerize the oligomer. The oligomer can be cured thermally, using ultraviolet light and/or using electron beam. Preferably, the oligomer is cured by thermal technique by heating to elevated temperature of 150 to 250°C. The exposure to elevated temperature is usually carried out for one-half to 5 hours, and preferably one-half to two hours.

The Figure illustrates a cross section of an assembly of a carrier and a chip in accordance with the present invention.

Numeral 1 illustrates the substrate through which pins 2 extend or protrude from the back side thereof. Numeral 3 represents a small portion of the pins protruding on the top side of the substrate for carrying current thereto. The integrated circuit chip, such as a silicon or polycrystalline silicon chip, is represented by numeral 4 and is attached to substrate 1 with solder 9. In addition, the chip can be one of the preferred chips which is passivated or coated with quartz or a polyimide. The substrate is preferably a ceramic substrate. A ceramic is a product or material manufactured by the action of heat on earth raw materials. The preferred ceramic substrates include silicon oxides and silicates, such as aluminum silicate; and aluminum oxides.

Numeral 5 represents a top seal composition employed according to the present invention. In a typical application, the top seal is a continuous pinhole free film of thickness of 5 to 50 micrometers, and preferably 12 to 25 micrometers.

Typical examples of preferred compositions employed according to the present invention are as follows:

Example 1

20 mg of poly(1,3,5-triethynylbenzene) prepared in accordance with Example 2 of U.S. Patent 4,273,906 and having 6—20% free ethynyl groups per aromatic ring, $\overline{M}_z$ of 1500 to 2500, $\overline{M}_w$ of 1000 to 1200, and $\overline{M}_n$ of 700 to 900 are dissolved in 1 ml of a solvent containing 1-methyl-2-pyrrolidinone and ethoxyethanol in a ratio of 1:4. About 100 µliter of the composition is dispersed on a 24 mm substrate containing a single silicon chip. This amount is equivalent to about 2 mg of polymer per substrate. The substrates are loaded on firing sticks and are then placed in a drying oven at 80—90°C for 1 hour. The temperature is then raised to 150°C and maintained there for 1 hour.

The solution wets and coats the entire surface of the module including underneath the chip. Upon drying and curing a continuous moisture-resistant film is produced.

Example 2

20 mg of poly(1,3,5-triethynylbenzene) prepared in accordance with Example 2 of U.S. Patent 4,273,906 and having 6—20% free ethynyl groups per aromatic ring, $\overline{M}_z$ of 1500 to 2500, $\overline{M}_w$ of 1000 to 1200, and $\overline{M}_n$ of 700 to 900 are dissolved in 1 ml of a solvent containing 1-methyl-2-pyrrolidinone and 1-butanol in a ratio of 1:1. About 180 µl of the composition is dispersed onto each 28 mm substrate. The substrates are loaded onto firing sticks and are dried at 85—90°C for 1 hour and cured at 170°C for 2 hours.

The solution wets and coats the entire surface of the module including underneath the chip. Upon drying and curing, a continuous, moisture-resistant film is produced.

Example 3

16 mg of poly(1,3,5-triethynylbenzene) prepared in accordance with Example 2 of U.S. Patent 4,273,906 and having 6—20% free ethynyl groups per aromatic ring, $\overline{M}_z$ of 1500—2500, $\overline{M}_w$ of 1000 to 1200, and $\overline{M}_n$ of 700 to 900 and 8 mg of H-resin available from Hercules Incorporated are dissolved in 1 ml of a solvent combination of 1-methyl-2-pyrrolidinone and 1-butanol in a ratio of 2:3. 100 µl of the composition is dispersed onto a 24 mm substrate. The substrates are loaded on firing sticks and then placed in a drying oven at 90°C for 1 hour followed by a cure at 150°C for 3 hours.

The solution wets and coats the entire surface of the module including underneath the chip. Upon drying and curing, a continuous, moisture-resistant film is produced.

**Claims**

1. Use of a soluble polymerizable oligomer having a number average molecular weight of from 200 to 10,000, having more than two appendant acetylenic groups and having the formula:

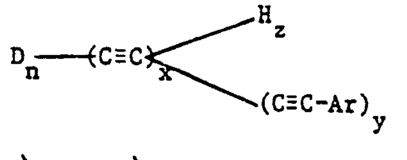

wherein D is

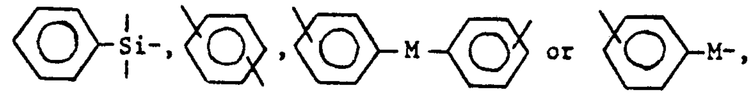

wherein M is

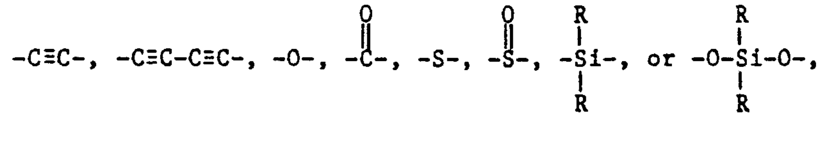

wherein R is an alkyl or aromatic group; wherein Ar is an aromatic group; wherein x is the number of appendant acetylenic groups and is an integer greater than 2 but less than 30, z is either zero or an integer, and y is an integer with the sum of y and z equal to x; and wherein n is an integer from 1 to 10, as a top seal for solder connector patterns under an integrated circuit chip attached to a substrate, to form an electronic circuit component.

2. The component of claim 1 wherein said oligomer has a molecular weight of 400 to 2000.

3. The component of claim 1 or 2 wherein at least 60% of the acetylenic groups of the oligomer are diacetylenic groups.

4. The component of any preceding claim wherein each oligomer molecule contains at least two diacetylenic groups and said groups constitute most of the appendant acetylenic groups of the oligomer.

5. The component of any preceding claim wherein said oligomer contains up to 20% by weight of ethynyl content.

6. The component of any preceding claim wherein said oligomer is obtained from 1,3,5-triethynylbenzene.

7. The component of any preceding claim wherein said oligomer has 6 to 20% free ethynyl groups per aromatic ring, a $\overline{M}_z$ of 1500 to 2500, a $\overline{M}_w$ of 1000 to 1200, and a $\overline{M}_n$ of 700 to 900.

8. The component of any preceding claim wherein said film is formed from a composition containing said oligomer and a plasticizer or a toughening agent or both.

9. The component of claim 8 wherein said plasticizer is selected from the group of diphenyldiacetylene, diphenylbutadiene, diphenylether, phenyltriethynyl silane, 4,4'-diethynyl diphenyl ether or mixtures thereof and said toughening agent is selected from the group of aromatic diphenylether, cyclized poly(arylacetylene) polymers, acrylonitrile polymers, polyimides, polyquinoxalines, polyesters, polysilicones or mixtures thereof.

10. The component of claim 9 wherein said toughening agent is selected from the group of aromatic diphenyl ether and cyclized poly(arylacetylene) polymers.

11. The component of claim 8, 9 or 10 wherein the plasticizer or toughening agent or both is employed in amounts of 10 to 75% by weight based upon the oligomer, or preferably in amounts of 25 to 50%.

12. The component of any preceding claim wherein the continuous top seal film is formed from a composition which also contains a reactive acetylenic solvent for said oligomer.

13. The component of claim 12 wherein said acetylenic solvent is represented by the formula

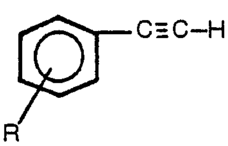

wherein R is H, halogen, lower alkyl, or lower alkoxy.

14. The component of any of claims 1—11 wherein the top seal continuous film is formed from a composition which also contains a non-reactive solvent, preferably an oxygen-containing solvent.

15. The component of claim 14 wherein said non-reactive solvent is selected from the group of alcohols, bis(2-methoxyethyl)ether, cyclohexanone, and 1-methyl-2-pyrrolidinone, and said oligomer is present in amounts of 5 to 80 mg per ml of solvent.

16. The component of claim 15 wherein said alcohol is selected from the group of 1-butanol and 2-ethoxyethanol.

17. A method for providing a top seal for solder connector patterns under an integrated circuit chip attached a substrate (1) which method comprises coating at least one major surface of said substrate with a composition containing a soluble polymerizable oligomer and then hardening the composition by further polymerization, said oligomer having an average molecular weight of 200 to 10,000, having more than two appendant acetylenic groups and having the formula:

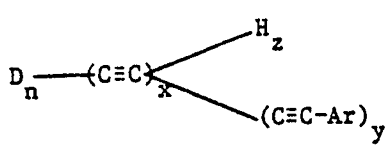

wherein D is

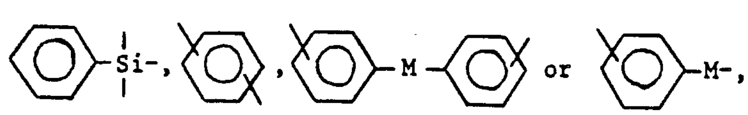

or

wherein M is

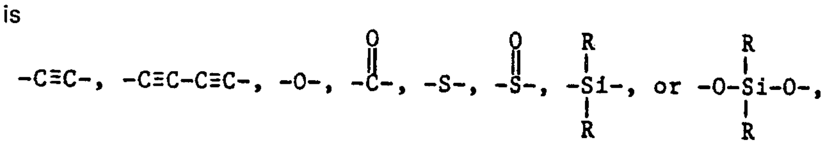

or

wherein R is an alkyl or aromatic group; wherein Ar is an aromatic group; x is the number of appendant acetylenic groups and is an integer greater than 2 but less than 30, z is either zero or an integer, y is an integer with the sum of y and z equal to x; and wherein n is an integer from 1 to 10.

18. The method of claim 17 wherein said composition is subjected to an elevated temperature of from 150 to 250°C, for ½ to 5 hours, to cause further polymerization.

19. The method of claim 17 or 18 wherein the thickness of said coating after polymerization is 5 to 50 micrometers, or preferably 12 to 25 micrometers.

20. The method of any one of claims 17—19, characterized by: said composition further comprising either a plasticizer selected from the group of diphenyldiacetylene, diphenylbutadiene, diphenylether, phenyltriethynyl silane, 4,4'-diethynyldiphenylether or mixtures thereof; or a toughening agent selected from the group of cyclized poly(arylacetylene) polymer, aromatic diphenylether, acrylonitrile polymer, polyimides, polyquinoxalines, polyesters or polysilicones, or mixtures thereof; or both.

21. The method of claim 20 wherein said oligomer is obtained from 1,3,5-triethynylbenzene.

22. The method of claim 20 or 21 wherein said oligomer has a molecular weight of 400 to 2000, at least 60% of the acetylenic groups thereof are diacetylenic groups, each molecule of the oligomer contains at least two diacetylenic groups, and the oligomer contains up to 20% by weight of ethynyl content.

23. The method of claim 20, 21 or 22 wherein said oligomer has about 6 to 20% free ethynyl groups per aromatic ring, a $\overline{M}_z$ of 1500 to 2500, a $\overline{M}_w$ of 1000 to 1200, and a $\overline{M}_n$ of 700 to 900.

**Patentansprüche**

1. Anwendung eines löslichen polymerisierbaren Oligomers, mit einem durchschnittlichen Molekulargewicht von 200 bis 10 000, mit mehr als zwei anhängenden Acetylengruppen und der Formel:

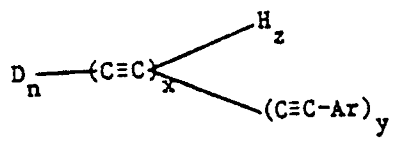

wobei D

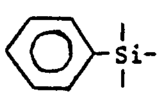, 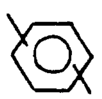, 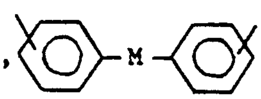 oder 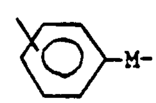 ist

wobei M

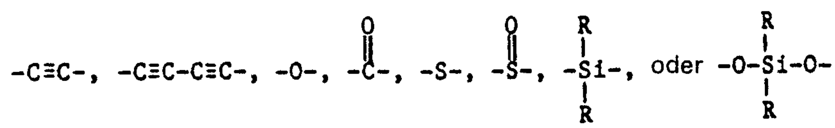 ist,

wobei R eine Alkylgruppe oder aromatische Gruppe ist; wobei Ar eine aromatische Gruppe ist; wobei x die Anzahl anhängender Acetylengruppen und eine ganze Zahl größer als 2, jedoch kleiner als 30 ist, z ist entweder null oder eine ganze Zahl und y ist eine ganze Zahl mit der Summe von y und z gleich x; und wobei n eine ganze Zahl von 1 bis 10 ist, als Oberflächenversiegelung für Lötverbindungsmuster unter einem, auf einem Substrat aufgebrachten IC-Chip, so daß ein elektronisches Schaltungs-bauelement gebildet wird.

2. Bauelement nach Anspruch 1, dadurch gekennzeichnet, daß das Oligomer ein Molekulargewicht von 400 bis 2000 aufweist.

3. Bauelement nach Anspruch 1 oder 2, dadurch gekennzeichnet, daß mindestens 60% der Acetylengruppen des Oligomers Diacetylengruppen sind.

4. Bauelement nach einem der vorhergehenden Ansprüche, dadurch gekennzeichnet, daß jedes Oligomermolekül mindestens zwei Diacetylengruppen enthält und daß diese Gruppen die meisten der anhängenden Acetylengruppen des Oligomers bilden.

5. Bauelement nach einem der vorhergehenden Ansprüche, dadurch gekennzeichnet, daß das Oligomer bis zu 20 Gew.% Äthynyl-Gehalt enthält.

6. Bauelement nach einem der vorhergehenden Ansprüche, dadurch gekennzeichnet, daß das Oligomer aus 1,3,5-Triäthynylbenzin gewonnen wird.

7. Bauelement nach einem der vorhergehenden Ansprüche, dadurch gekennzeichnet, daß das Oligomer 6 bis 20% freie Äthynylgruppen pro aromatischem Ring aufweist, einen $\overline{M}_z$ von 1500 bis 2500, einen $\overline{M}_w$ von 1000 bis 1200 und einen $\overline{M}_n$ von 700 bis 900.

8. Bauelement nach einem der vorhergehenden Ansprüche, dadurch gekennzeichnet, daß die Schicht aus einer Zusammensetzung aus dem Oligomer und einem Weichmacher bzw. einem Festigungsmittel oder beidem gebildet wird.

9. Bauelement nach Anspruch 8, dadurch gekennzeichnet, daß der Weichmacher aus der Gruppe Diphenyldiacetylen, Diphenylbutadien, Diphenyläther, Phenyltriäthynylsilan, 4,4'-Diäthynyl-Diphenyläther oder Gemischen daraus ausgewählt ist und das Festigungsmittel aus der Gruppe aromatischer Diphenyl-

äther, zyklisierte Poly(arylacetylen)-Polymere, Acrylonitril-Polymere, Polyimide, Poly-Chinoxaline, Polyesters, Polysilikone oder Gemischen daraus ausgewählt ist.

10. Bauelement nach Anspruch 9, dadurch gekennzeichnet, daß das Festigungsmittel aus der Gruppe des aromatischen Diphenyläthers und zyklisierter Poly(arylacetylen)-Polymere ausgewählt ist.

11. Bauelement nach Anspruch 8, 9 oder 10, dadurch gekennzeichnet, daß der Weichmacher bzw. das Festigungsmittel oder beides zwischen 10 und 75 Gew.% basierend auf dem Oligomer oder vorzugsweise zwischen 25 bis 50% verwendet wird.

12. Bauelement nach einem der vorhergehenden Ansprüche, dadurch gekennzeichnet, daß die kontinuierliche Oberflächenversiegelung aus einer Zusammensetzung gebildet ist, die auch ein reagierendes Acetylen-Lösungsmittel für das Oligomer enthält.

13. Bauelement nach Anspruch 12, dadurch gekennzeichnet, daß das Acetylen-Lösungsmittel durch die Formel

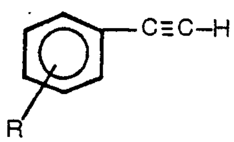

repräsentiert ist, wobei R H, Halogen, schwaches Alkyl oder schwaches Alkoxy ist.

14. Bauelement nach einem der Ansprüche 1—11, dadurch gekennzeichnet, daß die kontinuierliche Oberflächenversiegelung aus einer Zusammensetzung gebildet ist, die auch ein nichtreagierendes Lösungsmittel enthält, vorzugsweise ein sauerstoffhaltiges Lösungsmittel.

15. Bauelement nach Anspruch 14, dadurch gekennzeichnet, daß das nichtreagierende Lösungsmittel aus der Gruppe der Alkohole, bis(2-Methoxyäthyl)Äther, Cyclohexanon und 1-Methyl-2-Pyrrolidinon ausgewählt ist und daß das Oligomer zwischen 5 bis 80 mg pro ml Lösungsmittel vorhanden ist.

16. Bauelement nach Anspruch 15, dadurch gekennzeichnet, daß der Alkohol aus der Gruppe 1-Butanol und 2-Äthoxyäthanol ausgewählt ist.

17. Verfahren zur Herstellung einer Oberflächenversiegelung für Lötverbindungsmister unter einem auf einem Substrat (1) aufgebrachten IC-Chip, wobei zumindest eine Hauptoberfläche des Substrats mit einer Zusammensetzung beschichtet wird, welche ein lösbares polymerisierbares Oligomer enthält und dann die Zusammensetzung durch weitere Polymerisation gehärtet wird, wobei das Oligomer ein durchschnittliches Molekulargewicht von 200 bis 10 000 und mehr als zwei anhängende Acetylengruppen aufweist und folgende Formel hat:

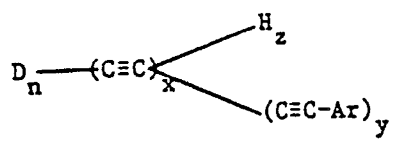

wobei D

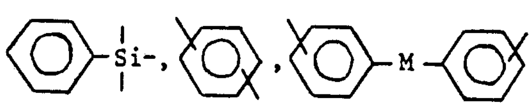 oder 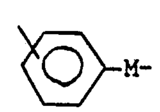 ist

wobei M

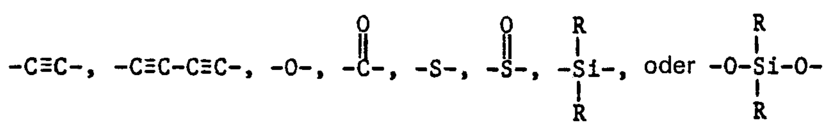

wobei R eine Alkylgruppe oder eine aromatische Gruppe ist; wobei Ar eine aromatische Gruppe ist; x ist die Anzahl der anhängenden Acetylengruppen und ist eine ganze Zahl größer als 2, aber kleiner als 30, z ist entweder null oder eine ganze Zahl, y ist eine ganze Zahl mit der Summe von y und z gleich x; und wobei n eine ganze Zahl von 1 bis 10 ist.

18. Verfahren nach Anspruch 17, dadurch gekennzeichnet, daß die Zusammensetzung einer erhöhten Temperatur von 150 bis 250°C für ½ bis 5 Std. ausgesetzt wird, so daß weitere Polymerisation erfolgt.

19. Verfahren nach Anspruch 17 oder 18, dadurch gekennzeichnet, daß die Beschichtungsdicke nach der Polymerisation 5 bis 50 Mikrometer oder vorzugsweise 12 bis 25 Mikrometer beträgt.

20. Verfahren nach einem der Ansprüche 17 bis 19, dadurch gekennzeichnet, daß die Zusammensetzung ferner entweder einen Weichmacher aus der Gruppe Diphenyldiacetylen, Diphenylbutadien, Diphenyläther, Phenyltriäthynylsilan, 4,4'-Diäthynyldiphenyläther oder Gemische daraus aufweist; bzw. ein Festigungsmittel aus der Gruppe zyklisierter Poly(Arylacetylen)Polymer, aromatischer Diphenyläther, Acrylonitril-Polymer, polyimide, Polychinoxaline, Polyester oder Polysilikone oder Gemische daraus, oder beides aufweist.

21. Verfahren nach Anspruch 20, dadurch gekennzeichnet, daß das Oligomer aus 1,3,5-Triäthynylbenzin gewonnen wird.

22. Verfahren nach Anspruch 20 oder 21, dadurch gekennzeichnet, daß das Oligomer ein Molekulargewicht von 400 bis 2000 hat, daß zumindest 60% der Acetylengruppen davon Diacetylengruppen sind, daß jedes Molekül des Oligomers zumindest zwei Diacetylengruppen enthält und daß das Oligomer bis zu 20 Gew.% Äthynylgehalt aufweist.

23. Verfahren nach Anspruch 20, 21 oder 22, dadurch gekennzeichnet, daß das Oligomer ca. 6 bis 20% freie Äthynylgruppen pro aromatischem Ring aufweist, eine $\overline{M}_z$ von 1500 bis 2500, eine $\overline{M}_w$ von 1000 bis 1200 und eine $\overline{M}_n$ von 700 bis 900 aufweist.

**Revendications**

1. Utilisation d'un ologomère polymerisable soluble, ayant une masse moléculaire moyenne en nombre comprise entre 200 et 10.000, comportant plus de deux groupes acétyléniques insérés et répondant à la formule:

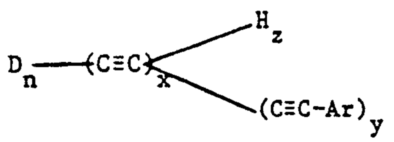

dans laquelle D est

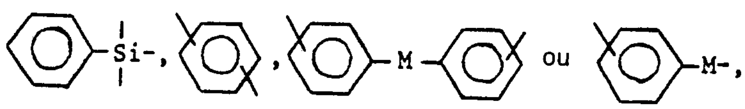

où M est

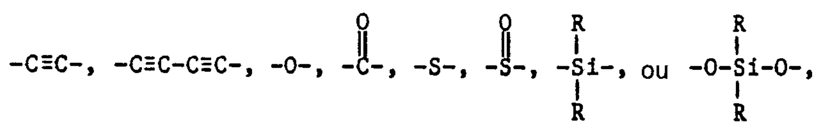

R étant un groupe alkyle ou aromatique; Ar étant un groupe aromatique; *x* étant le nombre de groupes acétyléniques insérés et étant un nombre entier supérieur à 2 mais inférieur à 30, z étant 0 ou un nombre entier et *y* étant un nombre entier, la somme de y + z étant égale à x; et *n* étant un nombre entier de 1 à 10; comme joint d'étanchéité et de recouvrement pour des motifs de connexions par soudure, sous une pastille de circuit intégré fixée à un substrat, pour former un composant de circuit électronique.

2. Composant selon la revendication 1, dans lequel ledit oligomère présente une masse moléculaire de 400 à 2000.

3. Composant selon la revendication 1 ou 2, dans lequel au moins 60% des groupes acétyléniques de l'oligomère sont des groupes diacétyléniques.

4. Composant selon l'une quelconque des revendications précédentes, dans lequel chaque molécule d'oligomère contient au moins deux groupes diacétyléniques et lesdits groupes constituent la majeure partie des groupes acétyléniques insérés de l'oligomère.

5. Composant selon l'une quelconque des revendications précédentes, dans lequel ledit oligomère contient jusqu'à 20% en poids de groupes éthynyles.

6. Composant selon l'une quelconque des revendications précédentes, dans lequel on obtient ledit oligomère à partir du 1,3,5-triéthynylbenzène.

7. Composant selon l'une quelconque des revendications précédentes, dans lequel ledit oligomère comporte de 6 à 20% de groupes éthynyles libres par noyau aromatique et présente une $\overline{M}_z$ de 1500 à 2500, une $\overline{M}_p$ de 1000 à 1200 et une $\overline{M}_n$ de 700 à 900.

8. Composant selon l'une quelconque des revendications précédentes, dans lequel ledit film est formé d'une composition contenant ledit oligomère et un agent plastifiant ou un agent de renforcement ou les deux.

9. Composant selon la revendication 8, dans lequel ledit plastifiant est choisi dans le groupe comprenant le diphényldiacétylène, le diphénylbutadiène, l'éther diphénylique, le phényltriéthynylsilane, l'éther 4,4'-diéthynyl-diphénylique ou un mélange de ceux-ci, et ledit agent de renforcement est choisi dans le groupe comprenant les éthers diphényliques aromatiques, les polymères poly(arylacétylène), cyclisés, les polymères d'acrylonitrile, les polyimides, les polyquinoxalines, les polyesters, les polysilicones ou leurs mélanges.

10. Composant selon la revendication 9, dans lequel ledit agent de renforcement est choisi dans le groupe comprenant les éthers diphényliques aromatiques et les polymères poly(arylacétylène) cyclisé.

11. Composant selon la revendication 8, 9 ou 10, dans lequel on utilise le plastifiant ou l'agent de renforcement ou les deux en des proportions de 10 à 75% par rapport au poids de l'oligomère ou, de préférence, en des proportions de 25 à 50%.

12. Composant selon l'une quelconque des revendications précédentes, dans lequel le film continu de joint d'étanchéité et de recouvrement est formé d'une composition qui contient également un solvant acétylénique réactif du dioligomère.

13. Composant selon la revendication 12, dans lequel ledit solvant acétylénique répond à la formule

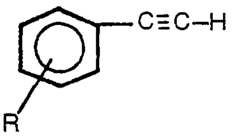

dans laquelle R est H, un halogène, un alkyle inférieur ou un alcoxy inférieur.

14. Composant selon l'une quelconque des revendications 1 à 11, dans lequel le film continu de joint d'étanchéité et de recouvrement est formé avec une composition qui contient également un solvant non réactif, de préférence un solvant oxygéné.

15. Composant selon la revendication 14, dans lequel ledit solvant non réactif est choisi parmi les alcools, l'éther bis(2-méthoxyéthylique), la cyclohexanone et la 1-méthyl-2-pyrrolidinone et ledit oligomère est présent à raison de 5 à 80 mg par ml de solvant.

16. Composant selon la revendication 15, dans lequel ledit alcool est choisi parmi le 1-butanol et le 2-éthoxyéthanol.

17. Procédé d'établissement d'un joint d'étanchéité et de recouvrement pour des motifs de connexions par soudure, sous une pastille de circuit intégré fixée à un substrat (1), procédé qui consiste à revêtir au moins une grande surface dudit substrat avec une composition contenant un oligomère polymérisable soluble et ensuite à faire durcir la composition par polymérisation ultérieure, ledit oligomère ayant une masse moléculaire moyenne comprise entre 200 et 10.000, portant plus de deux groupes acétyléniques insérés et répondant à la formule:

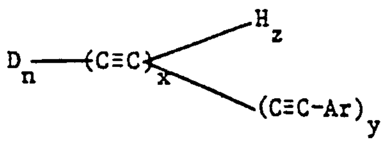

dans laquelle D est

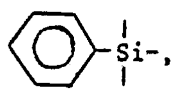, 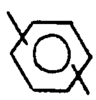, 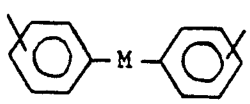 ou 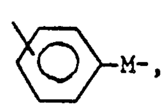,

où M est

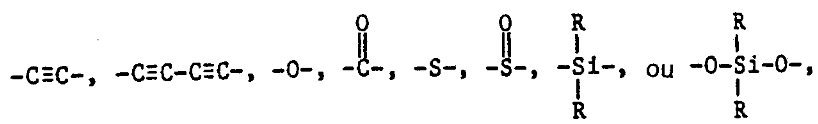

R étant un groupe alkyle ou aromatique; Ar étant un groupe aromatique; $x$ étant le nombre de groupes acétyléniques insérés et étant un nombre entier supérieur à 2 mais inférieur à 30, $z$ étant 0 ou un nombre entier, $y$ étant un nombre entier, la somme $y + z$ étant égale à x; et $n$ étant un nombre entier de 1 à 10.

18. Procédé selon la revendication 17, dans lequel on soumet ladite composition à une température élevée, de 150 à 250°C, pendant 0,5 à 5 heures, pour effectuer la polymérisation ultérieure.

19. Procédé selon la revendication 17 ou 18, dans lequel l'épaisseur dudit revêtement, aprés polymérisation, est comprise entre 5 et 50 µm et, de préférence, entre 12 et 25 µn.

20. Procédé selon l'une quelconque des revendications 17 à 19, caractérisé en ce que ladite composition comprend également un plastifiant choisi parmi le diphényldiacétylène, le diphénylbutadiène, l'éther diphénylique, le phényltriéthynylsilane, l'éther 4,4'-di-éthynyldiphénylique ou leur mélanges; ou un agent de renforcement choisi parmi les polymères poly(arylacétylène) cyclisés, les éthers diphényliques aromatiques, les polymères d'acrylonitrile, les polyimides, les polyquinoxalines, les polyesters, ou les polysilicones, ou leurs mélanges; ou les deux.

21. Procédé selon la revendication 20, dans lequel ledit oligomère est obtenu à partir du 1,3,5-triéthynylbenzène.

22. Procédé selon la revendication 20 ou 21, dans lequel ledit oligomère présente une masse moléculaire comprise entre 400 et 2000, au moins 60% de ses groupes acétyléniques sont des groupes diacétyléniques, chaque molécule de l'oligomère contient au moins deux groupes diacétyléniques et l'oligomère contient jusqu'à 20% en poids de groupes éthynyles.

23. Procédé selon la revendication 20, 21 ou 22, dans lequel ledit oligomère contient environ 6 à 20% de groupes éthynyles libres par noyau aromatique, et présente une $\overline{M}_z$ de 1500 à 2500, une $\overline{M}_p$ de 1000 à 1200 et une $\overline{M}_n$ de 700 à 900.

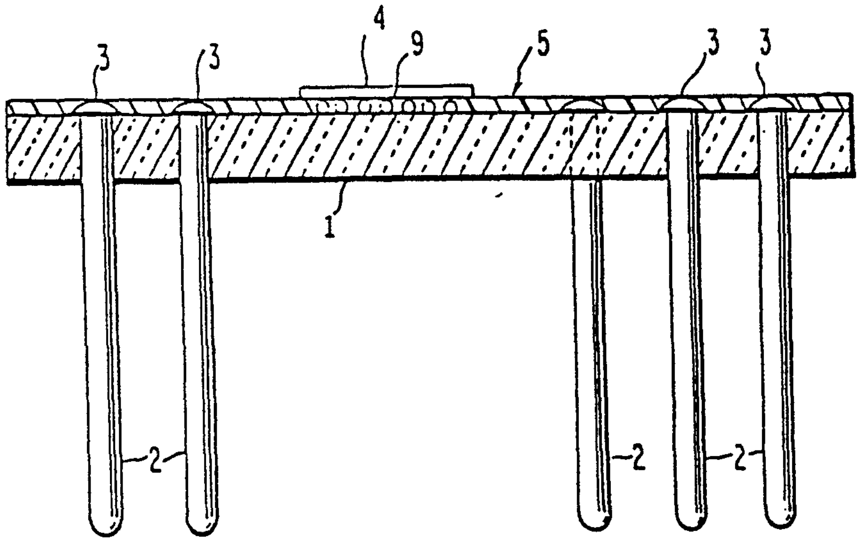
4
9
5
3
3
3
3
1
2
2
2
2